# EUROPÄISCHE PATENTSCHRIFT

(11) **EP 0 596 233 B1**
(45) Veröffentlichungstag und Bekanntmachung des Hinweises auf die Patenterteilung: **15.01.1997**
(21) Anmeldenummer: 93115300.1
(22) Anmeldetag: 23.09.1993
(51) Int. Cl.: F02P 17/00, G01R 31/00

(54) **Vorrichtung zum Erfassen von Hochspannungssignalen**
High voltage signals detection device
Dispositif de détection de signaux haute tension

(30) Priorität: 31.10.1992 DE 4236878
(43) Veröffentlichungstag der Anmeldung: 11.05.1994
(73) Patentinhaber: ROBERT BOSCH GMBH, 70442 Stuttgart (DE)
(72) Erfinder: Dittmann, Karl-Heinz, D-73054 Eislingen (DE); Bumen, Werner, D-73230 Kirchheim (DE)

(56) Entgegenhaltungen:
- EP-A- 0 508 804
- EP-A- 0 513 995
- DE-A- 4 028 554
- DE-A- 4 207 140

## Beschreibung

### Stand der Technik

Die Erfindung geht aus von einer Vorrichtung zum Erfassen von Hochspannungssignalen nach der Gattung des Hauptanspruchs. Aus der DE-A 40 28 554 ist eine gattungsgemäße Vorrichtung bekannt, bei der die an einer Zündspule auftretende sekundäre Hochspannung mit einer kapazitiven Kopplung erfaßt wird. Die Zündspule ist Teil einer Zündanlage, die zur Zündung fremdgezündeter Brennkraftmaschinen vorgesehen ist. Die Zündspule enthält eine integrierte Diode, die im Sekundärkreis der Zündspule angeordnet ist. Die Diode bewirkt, daß die an einer Zündkerze auftretende Hochspannung stets nur eine vorgegebene Polarität aufweisen kann. Mit dieser Maßnahme werden unerwünschte Zündfunken verhindert, die beim Übergang zu einer Schließphase der Zündanlage auftreten könnten. Die kapazitive Kopplung erfaßt unmittelbar die an der Sekundärwicklung der Zündspule liegende Hochspannung. Im Außenbereich des Zündspulenkörpers ist ein Meßpunkt festgelegt, an welchem ein Signalaufnehmer anzubringen ist.

Der Erfindung liegt die Aufgabe zugrunde, eine möglichst vollständige Diagnose von Hochspannungssignalen an einer eine integrierte Diode enthaltenden Zündspule zu ermöglichen.

Die Aufgabe wird durch die im Hauptanspruch angegebenen Merkmale gelöst.

### Vorteile der Erfindung

Die erfindungsgemäße Vorrichtung zum Erfassen von Hochspannungssignalen weist den Vorteil auf, daß Fehler im Zündkreis, beispielsweise unzulässig hohe Nebenschlüsse oder gar Kurzschlüsse sowie Defekte an der integrierten Diode erkennbar sind. Insbesondere ein Vergleich der vor und nach der Diode auftretenden Signale ermöglicht eine Aussage über den Zustand der Diode.

Vorteilhafte Weiterbildungen und Verbesserungen der erfindungsgemäßen Vorrichtung ergeben sich aus Unteransprüchen.

Die Ausgestaltung der zweiten kapazitiven Kopplung mit einem Ansteckteil, das an einem zwischen der Zündspule und der Zündkerze liegenden Verbindungsstück angebracht wird, ermöglicht eine besonders einfache Adaption.

In einer vorteilhaften Weiterbildung ist das Ansteckteil mit einer elektrisch isolierenden Oberfläche versehen. Vorteile dieser Maßnahme ergeben sich insbesondere bei Zündanlagen, deren Zündspule unmittelbar in Zündkerzennähe montiert sind. Kurzschlüsse gegen in der Nähe liegende Motorteile werden dadurch vermieden.

Weitere vorteilhafte Weiterbildungen und Ausgestaltungen ergeben sich aus weiteren Unteransprüchen in Verbindungm mit der folgenden Beschreibung.

### Zeichnung

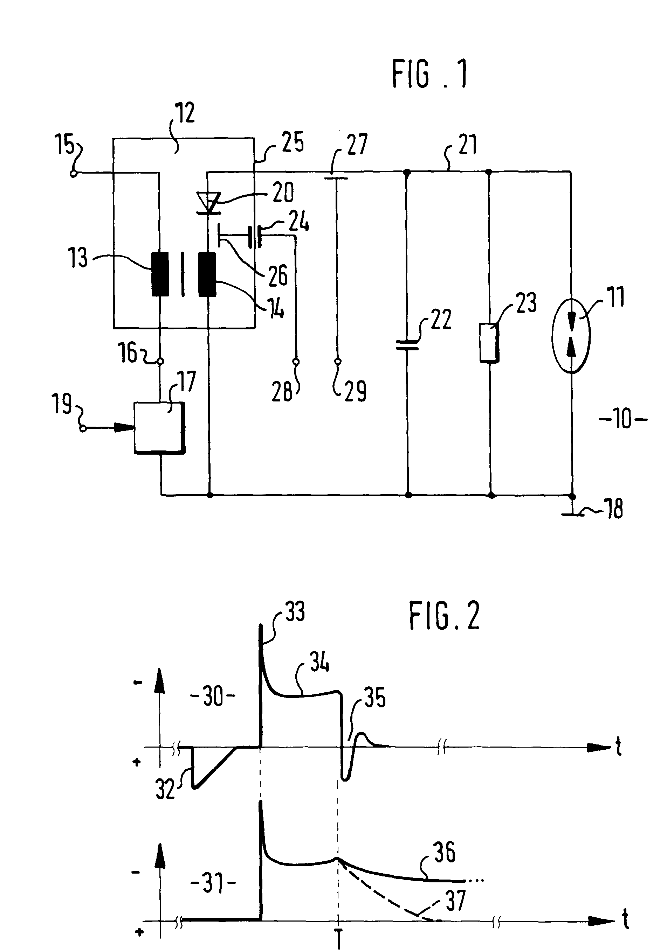

Figur 1 zeigt ein Blockschaltbild einer erfindungsgemäßen Vorrichtung zum Erfassen von Hochspannungssignalen und Figur 2 zeigt zwei Signalverläufe in Abhängigkeit von der Zeit, die in der in Figur 1 gezeigten Vorrichtung auftreten.

Figur 1 zeigt eine Zündanlage 10, die zum Erzeugen von Funken an einer Zündkerze 11 vorgesehen ist. Die Zündanlage 10 enthält eine Zündspule 12, die zumindest eine Primärwicklung 13 und zumindest eine Sekundärwicklung 14 aufweist. Ein erster Anschluß 15 der Primärwicklung 13 ist mit einer nichtgezeigten Energiequelle verbindbar. Ein zweiter Anschluß 16 der Primärwicklung 13 ist über Schaltmittel 17 mit einer Masse 18 verbindbar. Die Schaltmittel 17 sind über einen Steuereingang 19 betätigbar.

Die Sekundärwicklung 14 ist einerseits mit Masse 18 und andererseits mit einem Kathodenanschluß einer Diode 20 verbunden. Ein Anodenanschluß der Diode 20 ist mit einer Hochspannungsleitung 21 verbunden, die zur Zündkerze 11 führt.

Zwischen der Hochspannungsleitung 21 und der Masse 18 sind ein Kondensator 22 und ein Widerstand 23 eingetragen. Der Kondensator 22 sowie der Widerstand 23 sind als Bauelemente nicht vorhanden. Der Kondensator 22 symbolisiert die unvermeidliche Kapazität zwischen der Hochspannungsleitung 21 und der Masse 18 und der Widerstand 23 symbolisiert einen zwischen der Hochspannungsleitung 21 und der Masse 18 auftretenden Nebenschluß.

An der Zündspule 12 ist eine erste kapazitive Kopplung 24 angeordnet, die an einer definierten Stelle eines Gehäuses 25 der Zündspule 12 vorgesehen ist. Die erste kapazitive Kopplung 24 erfaßt die an der Sekundärwicklung 14 vor der Diode 20 auftretende Hochspannung. Sofern die Verbindung zwischen Sekundärwicklung 14 und Diode 20 nicht unmittelbar am Gehäuse 25 liegt, kann die erste kapazitive Kopplung 24 mit einem innerhalb des Gehäuses 25 der Zündspule 12 liegenden Verlängerungsteils 26 an die gewünschte Stelle geführt werden. Im Bereich zwischen Diode 20 und der Zündkerze 11 ist eine zweite kapazitive Signalkopplung 27 zum Erfassen der an der Hochspannungsleitung 21 auftretenden Hochspannungssignale vorgesehen. Die erste kapazitive Kopplung 24 ist zu einem Anschluß 28 und die zweite kapazitive Kopplung 27 zu einem Anschluß 29 geführt. Die Anschlüsse 28, 29 sind mit einer nicht näher gezeigten Diagnosevorrichtung verbindbar.

Figur 2 zeigt zwei Signalverläufe 30, 31 in Abhängigkeit von der Zeit t. Der im oberen Bild von Figur 2 gezeigte ersten Signalverlauf 30 zeigt die von der ersten kapazitiven Signalkopplung 24 ausgekoppelte sekundäre Hochspannung, die an der Sekundärwicklung 14 der Zündspule 12 auftritt. Der im unteren Teil von Figur 2 dargestellte zweite Signalverlauf 31 zeigt die mit der zweiten kapazitiven Signalkopplung 27 erfaßbare Hochspannung an der Hochspannungsleitung 21.

Der erste Signalverlauf 30 beginnt mit einem Spannungssprung 32, der zu Beginn einer Schließphase des Schaltmittels 17 auftritt. Die Schließphase wird mit einem entsprechenden Signal am Steuereingang 19 des Schaltmittels 17 eingeleitet. Vor Beginn der Schließphase liegt am zweiten Anschluß 16 der Primärwicklung 13 ein Potential, das dem am ersten Anschluß 15 auftretenden Potential entspricht. Die Verbindung des zweiten Anschlusses 16 mit Masse 18 beim Beginn des Schließvorgangs hat einen Potentialsprung am zweiten Anschluß 16 zur Folge, der auf die Sekundärseite übertragen wird und dort als Spannungsprung 32 auftritt. Die Polarität des Spannungsprungs 32 hängt von der Schaltungsanordnung ab. Wesentlich ist, daß der Spannungsprung 32 entgegengesetzt gerichtet ist zur nachfolgenden Zündnadel 33, die nach Beendigung der Schließphase auftritt. Der Spitzenspannungswert der Zündnadel 33 entspricht der Durchbruchspannung für den Zündfunken an der Zündkerze 11. An die Zündnadel 33 schließt sich eine Brennspannungslinie 34 an, die mit einem Funkenabriß zum Zeitpunkt T beendet ist. Nach dem Zeitpunkt T findet ein Ausschwingvorgang 35 statt, dessen Verlauf hauptsächlich von der Induktivität der Sekundärwicklung 14 und der Kapazität des Kondensators 22 festgelegt ist.

Der im unteren Teil von Figur 2 gezeigte zweite Signalverlauf 31 unterscheidet sich von dem im oberen Teil von Figur 2 gezeigten ersten Signalverlauf 30 zunächst dadurch, daß insbesondere der im ersten Signalverlauf 30 enthaltene Spannungssprung 32 entfällt, der in Abhängigkeit von den an der Zündkerze 11 vorliegenden Bedingungen ausreichen könnte, um einen Zündfunken zu erzeugen. Sofern die Zündkerze 11 zur Zündung einer fremdgezündeten Brennkraftmaschine vorgesehen ist, muß ein solcher sogenannter Schließfunken unter allen Umständen vermieden werden, da er während der Kompressionsphase auftreten würde.

Die Zündnadel sowie die Brennspannungslinie im zweiten Signalverlauf 31 stimmt bis auf die Durchlaßspannung der Diode 20 und eine gegebenfalls durch die kapazitive Kopplung verursachte Nullpunktverschiebung mit dem ersten Signalverlauf 30 überein.

Ein weiterer Unterschied zwischen beiden Signalverläufen 30, 31 tritt nach dem Zeitpunkt T auf. Nach dem Funkenabriß an der Zündkerze 11 entfällt bei einem ordnungsgemäßen Zündkreis die elektrische Anbindung an Masse 18. Die Diode 20 und der Kondensator 22 bilden zusammen einen Spitzenwertdetektor. Nach dem Funkenabriß an der Zündkerze 11 bleibt deshalb das an der Hochspannungsleitung 21 liegende Potential auf einem zuletzt aufgetretenen Spitzenwert. Im zweiten Signalverlauf 31 ist nach dem Zeitpunkt T ein erster Abklingvorgang 36 eingetragen, der gegebenenfalls auftritt. Weiterhin ist ein zweiter möglicher Abklingvorgang 37 strichliniert eingetragen, der eine höhere Steigung aufweist.

Bereits mit der Auswertung eines der beiden Signalverläufe 30, 31 ist eine Diagnose an der Zündanlage 10 möglich. Die Auswertung und der Vergleich der beiden Signalverläufe 30, 31 erhöht jedoch die Diagnosemöglichkeiten erheblich. Insbesondere läßt ein Vergleich der beiden Signalverläufe 30, 31 Rückschlüsse auf den Zustand der Diode 20 zu. Die Auswertung des Abklingvorgangs 36, 37 ermöglicht eine Bewertung eines Nebenschlusses im Zündkreis. Der erste Abklingvorgang 36 entspricht einem guten hochohmigen Nebenschluß, der durch den Widerstand 23 symbolisiert wird, während der zweite Abklingvorgang 37 einem schlechten niederohmigen Nebenschluß entspricht.

Die beiden kapazitiven Kopplungen 24, 27 werden vorteilhaft jeweils mit einem Ansteckteil realisiert. Das erste Ansteckteil für die erste kapazitive Kopplung 24 ist an einem vorzugsweise bereits während der Herstellung der Zündspule 12 gekennzeichneten Anbringungsort zu befestigen. Das andere Ansteckteil der zweiten kapazitiven Kopplung 27 kann sowohl ebenfalls an einem geeigneten Ort unmittelbar am Gehäuse 25 der Zündspule 12 oder an der Hochspannungsleitung 21 angebracht werden. Neuere Konzepte von Zündanlagen 10 sehen, anstelle einer längeren Hochspannungsleitung 21 nur noch kurze, in Isolierteilen geführte Verbindungsstücke zwischen einer aufsteckbaren Zündspule 12 und der Zündkerze 10 vor. Dadurch entstehen teilweise beengte Einbauverhältnisse, die ein Anbringen zumindest der zweiten kapazitiven Kopplung 27 erschweren.

Besonders vorteilhaft hat es sich herausgestellt, wenn das Ansteckteil für die zweite kapazitive Kopplung 27 mit einer elektrisch isolierenden Oberfläche beschichtet ist, die das Auftreten von Kurzschlüssen gegen Masse 18 verhindert. Weiterhin hat es sich als zweckmäßig erwiesen, die von der zweiten kapazitiven Kopplung 27 zum Anschluß 29 führende Leitung elektrisch zu isolieren. Mit dieser Maßnahme wird im wesentlichen ebenfalls ein möglicher Kurzschluß gegen Masse 18 verhindert.

Die erfindungsgemäße Vorrichtung ist gleichermaßen geeignet zur Diagnose von Zweifunkenzündanlagen, bei denen beide Anschlüsse der Sekundärwicklung 14 der Zündspule 12 mit Zündkerzen verbunden sind.

## Patentansprüche

1. Vorrichtung zum Erfassen von Hochspannungssignalen an einer eine integrierte Diode enthaltenden Zündspule, mit einer kapazitiven Signalauskopplung, die zur Erfassung der an einer Sekundärwicklung der Zündspule auftretenden Hochspannung vorgesehen ist, dadurch gekennzeichnet, daß eine weitere kapazitive Signalkopplung (27) vorgesehen ist, welche die zwischen der Diode (20) und wenigstens einer Zündkerze (11) auftretende Hochspannung erfaßt.

2. Vorrichtung nach Anspruch 1, dadurch gekennzeichnet, daß die weitere kapazitive Kopplung 27 als Ansteckteil ausgebildet ist, das an einer zwischen der Zündspule (12) und der Zündkerze (11) liegenden Hochspannungsleitung (21) anbringbar ist.

3. Vorrichtung nach Anspruch 2, dadurch gekennzeichnet, daß das Ansteckteil mit einer elektrisch isolierenden Oberfläche versehen ist.

4. Vorrichtung nach Anspruch 1, dadurch gekennzeichnet, daß die erste kapazitive Kopplung (24) mit einem Ansteckteil realisiert ist, das an einer markierten Stelle am Gehäuse (25) der Zündspule (12) anbringbar ist.

## Claims

1. Device for detecting high-voltage signals at an ignition coil containing an integrated diode, having a capacitive signal extraction means which is provided for detecting the high voltage occurring at a secondary winding of the ignition coil, characterized in that a further capacitive signal coupling means (27) is provided which detects the high voltage occurring between the diode (20) and at least one spark plug (11).

2. Device according to Claim 1, characterized in that the further capacitive coupling means 27 is constructed as a plug-on component which can be attached to a high-voltage line (21) located between the ignition coil (12) and the spark plug (11).

3. Device according to Claim 2, characterized in that the plug-on component is provided with an electrically insulating surface.

4. Device according to Claim 1, characterized in that the first capacitive coupling means (24) is realized with a plug-on component which can be attached to a marked point at the housing (25) of the ignition coil (12).

## Revendications

1. Dispositif de détection de signaux haute tension sur une bobine d'allumage, contenant une diode intégrée avec un couplage capacitif de signaux prévu pour la détection de la haute tension qui se produit sur un enroulement secondaire de la bobine d'allumage,
dispositif caractérisé en ce qu'
on prévoit un autre couplage capacitif de signaux (27) qui détecte la haute tension qui se produit entre la diode (20) et au moins une bougie d'allumage (11).

2. Dispositif selon la revendication 1,
caractérisé en ce que
l'autre couplage capacitif (27) est constitué sous la forme d'une pièce rapportée qui peut être mise sur une ligne haute tension (21) se trouvant entre la bobine d'allumage (12) et la bougie d'allumage (11).

3. Dispositif selon la revendication 2,
caractérisé en ce que
la pièce rapportée est pourvue d'une surface électriquement isolante.

4. Dispositif selon la revendication 1,
caractérisé en ce que
le premier couplage capacitif (24) est réalisé avec une pièce rapportée que l'on peut mettre en un endroit marqué sur le boîtier (25) de la bobine d'allumage (12).
